Europäisches Patentamt

European Patent Office

Office européen des brevets

(19)

(11) Numéro de publication: **0 234 994 B1**

## (12) FASCICULE DE BREVET EUROPEEN

(45) Date de publication de fascicule du brevet:
**25.09.91**

(51) Int. Cl.⁵: **G02F 1/133**

(21) Numéro de dépôt: **87400160.5**

(22) Date de dépôt: **23.01.87**

(54) **Ecran d'affichage à matrice active à résistance de drain et procédés de fabrication de cet écran.**

(30) Priorité: **27.01.86 FR 8601082**

(43) Date de publication de la demande:
**02.09.87 Bulletin 87/36**

(45) Mention de la délivrance du brevet:
**25.09.91 Bulletin 91/39**

(84) Etats contractants désignés:
**BE CH DE GB IT LI NL SE**

(56) Documents cités:
**EP-A- 0 103 523**

(73) Titulaire: **Maurice, François**
**125 Boulevard de la Corniche**
**F-22700 Perros-Guirec(FR)**

(72) Inventeur: **Maurice, François**
**125 Boulevard de la Corniche**
**F-22700 Perros-Guirec(FR)**

(74) Mandataire: **Mongrédien, André et al**
**c/o BREVATOME 25, rue de Ponthieu**
**F-75008 Paris(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

**Description**

La présente invention a pour objet un écran d'affichage à matrice active à résistance de drain et des procédés de fabrication de cet écran.

Un écran d'affichage à matrice active comprend généralement deux plaques entre lesquelles est intercalé un matériau électro-optique comme un cristal liquide. Sur l'une des plaques, on trouve une matrice de pavés conducteurs transparents, des transistors en couches minces, une famille de lignes conductrices d'adressage et une famille de colonnes conductrices d'adressage. Chaque transistor possède une grille reliée à une ligne, une source reliée à un pavé et un drain relié à une colonne. Sur la seconde plaque, on trouve une contre-électrode.

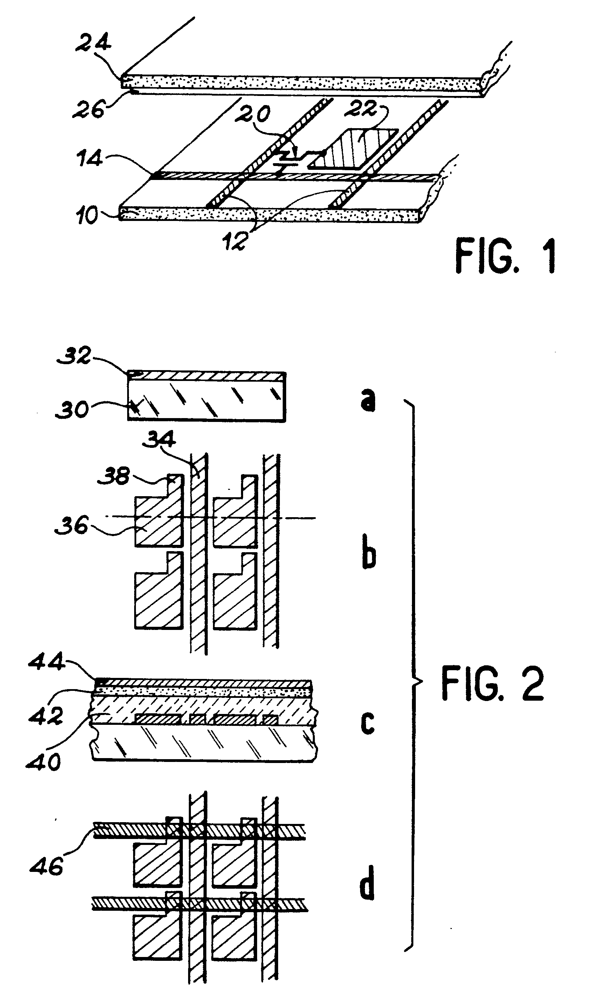

Une telle structure est représentée sur la figure 1. On y a représenté de manière simplifiée une plaque inférieure 10 portant des colonnes conductrices 12 et des lignes conductrices 14, un transistor 20, un pavé conducteur 22, et une plaque supérieure 24 recouverte d'une contreélectrode 26.

Pour obtenir une telle structure, on peut mettre en oeuvre un procédé dont les principales étapes sont illustrées sur la figure 2. Ce procédé comprend les opérations suivantes :
- préparation d'un substrat de verre 30 par nettoyage physico-chimique ;
- dépôt d'une couche 32 de matériau conducteur transparent, par exemple en oxyde d'étain et d'indium (ITO) (a) ;
- première photogravure, pour donner à la couche 32 la forme de colonnes 34 et de pavés 36 munis d'un appendice rectangulaire 38 (b) ;
- dépôts d'une couche de silicium amorphe hydrogéné 40, d'une couche de silice 42 et d'une couche d'aluminium 44, chaque dépôt étant effectué à environ 250°C (c),
- seconde photogravure, pour définir des lignes 46 chevauchant les appendices 38 et croisant les colonnes et définissant des transistors (d),
- passivation générale par dépôt d'une couche de SiO₂ (non représentée).

Un tel procédé, à deux niveaux de masquage, est décrit dans la demande de brevet français FR-A-2 533 072.

Malgré sa simplicité, ce procédé présente des inconvénients :
- tout d'abord, en cas de court-circuit drain-grille d'un transistor, une colonne entière se trouve en court-circuit avec une ligne,
- ensuite, la largeur d'une ligne, dans la zone où celle-ci croise une colonne, est déterminée par la largeur du canal du transistor, de sorte qu'on ne peut la réduire à volonté dans le but de diminuer les risques de court-circuit ligne-colonne,
- enfin, l'épaisseur de l'isolant qui sépare une ligne et une colonne est, par construction même, la même que celle de l'isolant situé sous la grille du transistor, de sorte que, là non plus, on n'est pas maître de l'accroissement de cette épaisseur en vue de réduire les risques de court-circuit.

Le but de l'invention est justement de remédier à ces inconvénients. A cette fin, l'invention telle que revendiquée dans la revendication 1 préconise l'utilisation d'une bande auxiliaire de matériau conducteur présentant une certaine résistivité, cette bande étant placée à côté de chaque pavé. Chaque transistor est alors formé dans la zone de chevauchement d'une ligne avec cette bande et avec l'appendice lié au pavé. Par ailleurs, chaque bande est reliée à une colonne. Tous les inconvénients énumérés plus haut sont alors éliminés :
- en cas de court-circuit drain-grille, la résistance présentée par la bande évite le court-circuit franc entre la ligne et la colonne,
- le drain du transistor n'est plus formé par la colonne, de sorte qu'il y a indépendance entre les transistors et les zones de croisements lignes-colonnes : on pourra réduire la largeur de la ligne à son passage au-dessus des colonnes sans réduire pour autant cette largeur au niveau des grilles des transistors ; on pourra aussi donner l'épaisseur de l'isolant séparant lignes et colonnes une valeur plus grande que l'épaisseur de l'isolant sous la grille des transistors.

On peut ajouter un autre avantage à cette liste. Dans une demande de brevet déposée par le présent Demandeur le même jour que la présente demande, il est décrit un écran d'affichage à matrice active dans lequel les lignes et/ou les colonnes sont reliées entre elles par une résistance. Cette disposition permet d'éviter les inconvénients liés à des coupures de lignes et de colonnes. En effet, en cas de coupure, la partie isolée se trouve portée à un potentiel égal à la demi-somme des potentiels des lignes ou des colonnes adjacentes. Mais une telle disposition suppose que les colonnes présentent une résistance pas trop élevée, ce qui n'est malheureusement pas le cas avec le procédé de l'art antérieur où le matériau constituant les colonnes est le même que le matériau constituant les pavés, c'est-à-dire en pratique, de l'ITO. Avec l'invention, la plus grande latitude est laissée pour la réalisation des colonnes, ce qui permet d'utiliser des matériaux moins résistifs. La technique en question est alors utilisable.

De façon précise, la présente invention a donc pour objet un écran d'affichage à matrice active comprenant une première plaque revêtue d'une matrice de pavés conducteurs, de transistors en couches minces, d'une famille de lignes conductrices d'adressage, et d'une famille de colonnes conductrices d'adressage chaque transistor ayant une grille reliée à une ligne, une source formée par un appendice relié à un pavé et un drain relié à une colonne, cet écran comportant encore une seconde plaque comprenant une contre-électrode et un matériau électro-optique inséré entre les deux parois, cet écran étant caractérisé par le fait que chaque connexion drain-colonne s'effectue par une bande de matériau conducteur présentant une certaine résistance, le drain de chaque transistor étant formé par la partie de cette bande située dans la zone où une ligne chevauche cette bande et par le fait que chaque ligne possède une certaine largeur dans la zone où sont formés les transistors et une autre largeur, plus faible que la première, dans la zone où elle se croise.

La présente invention a également pour objet des procédés de fabrication d'un écran tel qu'il vient d'être défini.

De toutes façons, les caractéristiques de l'invention apparaîtront mieux à la lecture de la description qui suit, d'exemples de réalisation donnés à titre explicatif et nullement limitatif. Cette description se réfère à des dessins annexés sur lesquels :

- la figure 1, déjà décrite, montre la structure d'un écran d'affichage à matrice active, selon l'art antérieur,
- la figure 2, déjà décrite, illustre un procédé de fabrication connu utilisé pour fabriquer un écran d'affichage à matrice active,
- la figure 3 montre un premier mode de mise en oeuvre du procédé de l'invention,
- la figure 4 montre un second mode de mise en oeuvre du procédé de l'invention,
- la figure 5 illustre une variante à double transistor de commande.

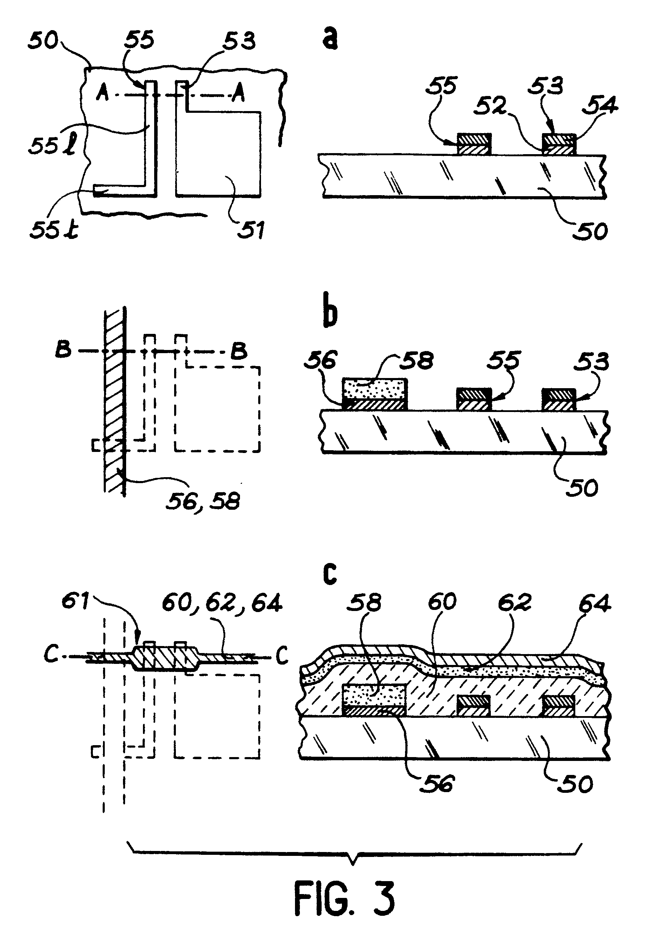

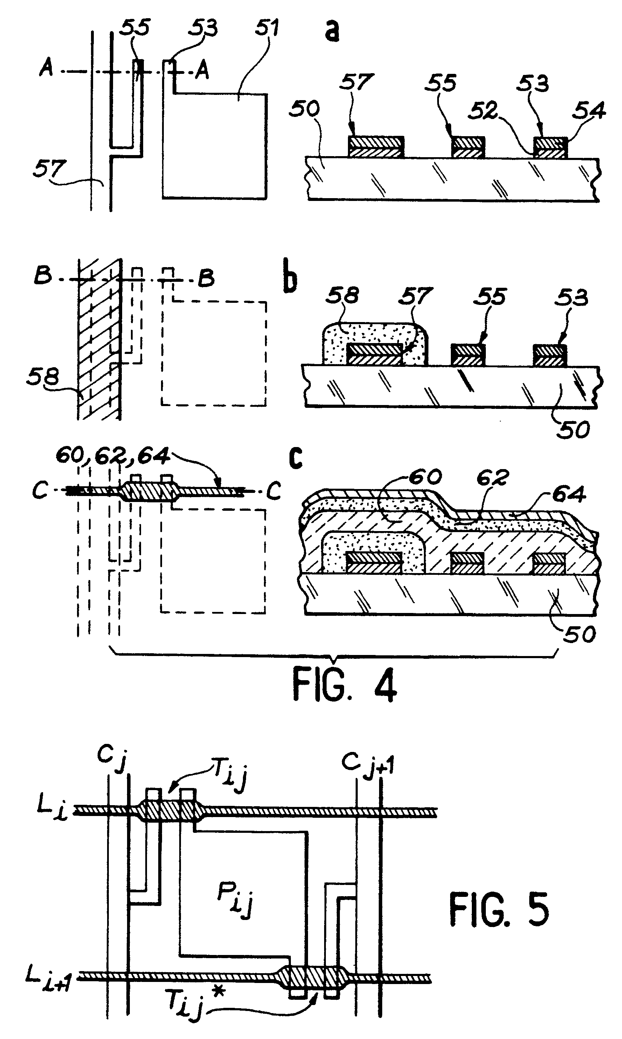

Sur les figures 3 et 4 qui vont être décrites, la partie gauche représente des vues de dessus et la partie droite des coupes, respectivement selon AA, BB et CC.

Sur la figure 3, on voit trois étapes (a, b, c) d'un premier mode de mise en oeuvre du procédé selon l'invention.

Les opérations effectuées sont les suivantes :

- dépôt sur un substrat isolant 50, par exemple en verre, d'une couche d'un matériau conducteur transparent 52 par exemple en oxyde d'étain et d'indium ITO et, éventuellement, d'une couche 54 de silicium amorphe dopé $n^+$,
- première photogravure de cette ou de ces couches pour former des pavés 51 ayant un appendice 53 et des bandes 55 ayant une partie longitudinale 55l qui longe le côté d'un pavé et l'appendice et une partie transversale

55t à angle droit (partie a) à la base de la bande,
- dépôt d'une couche 56 d'un premier métal et d'une couche d'un premier isolant 58,
- deuxième photogravure appliquée à ces deux couches pour dessiner des colonnes chevauchant la partie transversale des bandes, ce qui connecte les colonnes aux bandes (partie b), cette deuxième photogravure laissant intactes les couches de Si $n^+$ et d'ITO,
- dépôt d'un empilement formé d'une couche 60 de silicium amorphe hydrogéné aSi:H, d'une couche 62 d'un deuxième isolant et d'une couche 64 d'un second métal,
- troisième photogravure appliquée à l'empilement précédent pour former des lignes chevauchant les appendices des pavés et l'extrémité supérieure des bandes ; c'est dans ces zones de chevauchement que sont formés les transistors 61 ; cette troisième photogravure laisse intact le premier isolant. La largeur des lignes peut être plus grande dans la zone des transistors que dans les zones de croisement avec les colonnes (comme on le voit sur la partie c).

En pratique, le premier et le second isolants peuvent être tous deux de la silice $SiO_2$ et les premier et second métaux de l'aluminium.

On peut se rendre compte, sur cet exemple, que tous les buts poursuivis par l'invention sont atteints :

- la bande 55 constitue une résistance qui protège la colonne si le transistor claque. Si l'ITO fait $10^4 \Omega$ par carré et si la bande fait 10 carrés (5 $\mu m \times 50$ $\mu m$) alors cette résistance est de 100 k$\Omega$;, elle ne crée pas de chute de potentiel supérieure à 0,1 V lorsque le transistor est passant,
- la ligne est de largeur plus faible sur la colonne que sur le transistor,
- l'isolant de grille et l'isolant de croisement sont d'épaisseur et éventuellement de nature différentes.

Par ailleurs, le transistor est identique à celui des structures obtenues par le procédé décrit dans le document FR-A-2 533 072 déjà cité avec toutes les qualités qui en découlent.

Si l'on veut combiner la présente invention avec la disposition protégée dans la demande simultanée du même inventeur évoquée plus haut, il suffit de rajouter, lors du premier niveau de masquage, un rectangle en ITO, faisant le tour de la plaque et d'empêcher, au 3ème niveau de masquage, le dépôt de aSi:H et $SiO_2$ sur les extrémités droite et gauche de ce rectangle, afin qu'un contact puisse se faire avec le deuxième métal. Les lignes et les colonnes seront alors reliées entre elles par des bandes d'ITO à la périphérie du dispositif.

La figure 4 illustre un procédé légèrement différent qui comprend les opérations suivantes :

- sur un substrat isolant 50, dépôt d'une couche 52 de matériau conducteur transparent (par exemple en ITO) et éventuellement d'une couche 54 de silicium amorphe dopé $n^+$,
- première photogravure pour dessiner des pavés 51 munis d'un appendice 53, des colonnes 57 et des bandes 55 reliées aux colonnes,
- dépôt d'une couche 58 d'un premier isolant,
- deuxième photogravure appliquée à cet isolant sans toucher à Si $n^+$ ni à ITO, pour former des colonnes isolantes recouvrant les colonnes conductrices ; la largeur de l'isolant est de préférence plus grande que celle du métal de la colonne, de telle sorte que l'isolant déborde la colonne et l'isole complètement,
- dépôt d'un empilement constitué d'une couche 60 de aSi:H, d'une couche 62 d'un second isolant et d'une couche 64 d'un second métal,
- troisième photogravure de l'empilement précédent en épargnant l'ITO et, éventuellement, le premier isolant, pour dessiner des lignes passant au-dessus des appendices et au-dessus de la partie supérieure des bandes. Comme dans la variante précédente, la largeur de la ligne est de préférence plus étroite au croisement des colonnes que sur les transistors.

L'inconvénient de cette solution est que le matériau constituant les colonnes est de l'ITO ; sa résistance est donc grande, ce qui est incompatible avec la disposition protégée par la demande évoquée plus haut et déposée par le présent Demandeur. En revanche, l'isolement des colonnes est excellent.

Dans les deux procédés qui viennent d'être décrits on observera que la géométrie des transistors est peu sensible à l'alignement du masque utilisé pour la troisième photogravure, car la ligne qui définit le transistor chevauche deux bandes allongées (l'appendice et l'extrémité supérieure de la bande de connexion à la colonne), ce qui permet des incertitudes sur la position du masque.

Dans la seconde variante du procédé, illustrée sur la figure 4, on peut déposer sur l'ITO, avant le Si $n^+$ une couche métallique supplémentaire qui sera gravée en même temps que le Si $n^+$ lors de la troisième opération de gravure. L'avantage de cette variante est de conduire à des colonnes à double couches conductrices (ITO et métal), ce qui réduit leur résistance.

Dans ce qui précède, chaque pavé est muni d'un seul appendice et est commandé par un seul transistor. Mais l'invention peut fort bien s'appliquer au cas où chaque pavé est muni de deux appendices et est commandé par deux transistors, comme illustré sur la figure 5. Le pavé Pij est commandé par le transistor Tij relié à la ligne Li et à la colonne Cj et par le transistor Tij* relié à la ligne Li + 1 et à la colonne Cj + 1. On obtient ainsi une redondance qui peut être utile en cas de défaut au niveau d'un transistor. Si les deux transistors fonctionnent, l'image affichée est finalement décalée d'un pas vers la gauche et vers le haut.

Pour terminer, on peut indiquer que la présente invention peut être combinée avec une autre disposition qui fait l'objet d'une autre demande de brevet déposée le jour même du dépôt de la présente demande et qui préconise l'utilisation d'une couche résistive sous la grille du transistor. Si ces deux dispositions sont combinées, on obtient donc deux résistances de protection en série qui protègent efficacement l'écran contre les court-circuits grille-drain.

**Revendications**

1. Ecran d'affichage à matrice active comprenant une première plaque (10) revêtue d'une matrice de pavés conducteurs (22), de transistors de commande en couches minces (20), d'une famille de lignes conductrices d'adressage (14) et d'une famille de colonnes conductrices d'adressage (12), chaque transistor (20) ayant une grille reliée à une ligne, une source formée par un appendice relié à un pavé et un drain relié à une colonne, cet écran comportant encore une seconde plaque (24) comprenant une contre-électrode (26) et un matériau électro-optique inséré entre les deux plaques, cet écran étant caractérisé par le fait que chaque connexion drain-colonne s'effectue par une bande (55) de matériau conducteur présentant une résistance, dont la valeur est telle qu'elle protége la colonne si le transistor claque et que la chute de potentiel à travers ladite résistance est inférieure à une fraction de volt lorsque le transistor est passant, le drain de chaque transistor étant formé par la partie de la bande située dans la zone où une ligne chevauche cette bande et par le fait que chaque ligne possède une certaine largeur dans la zone où sont formés les transistors et une autre largeur, plus faible que la première, dans la zone où elle croise une colonne d'adressage.

2. Ecran d'affichage selon la revendication 1, caractérisé par le fait que la bande conductrice (55) est constituée dans le matériau même (52) qui constitue les pavés conducteurs.

3. Ecran d'affichage selon la revendication 2, caractérisé par le fait que ce matériau est de l'oxyde d'étain-indium (ITO).

4. Procédé de fabrication d'un écran d'affichage à matrice active conforme à la revendication 1, ce procédé consistant à réaliser une première plaque (10) portant des premières armatures de condensateurs (22), des transistors à couches minces (20), des lignes (14) et des colonnes (12) conductrices d'adressage, et à réaliser une paroi supérieure (24) revêtue d'une contre-électrode (26) formant seconde armature des condensateurs, ce procédé comprenant, pour réaliser la plaque inférieure, les opérations suivantes :
   - dépôt sur un substrat isolant (50) d'une couche d'un premier matériau conducteur (52, 54),
   - première photogravure appliquée à cette couche pour constituer des pavés (51) formant une des armatures des futurs condensateurs, chaque pavé possédant un appendice (53),
   - dépôt d'un empilement constitué d'une couche (60) de silicium amorphe hydrogéné, d'une couche (62) d'un matériau isolant, d'une couche (64) d'un matériau conducteur,
   - photogravure appliquée à cet empilement pour laisser subsister des lignes passant au-dessus des appendices (53) des pavés, ce procédé étant caractérisé par le fait que :
   - la première photogravure laisse subsister en outre des bandes (55) ayant une partie longitudinale (55l) s'étendant le long du pavé et de son appendice et une partie transversale (55t),
   - avant le dépôt de l'empilement on dépose une couche d'un matériau conducteur (56) et une couche d'un matériau isolant (58), ce dépôt étant suivi d'une photogravure additionnelle appliquée à ces deux dernières couches pour laisser subsister des colonnes parallèles à la partie longitudinale (55l) des bandes et en contact avec la partie transversale (55) de ces bandes,
   - les lignes passent au-dessus de l'extrémité des bandes (55) et ont une largeur pouvant être supérieure dans la région des transistors à celle dans les régions où elles croisent les colonnes.

5. Procédé de fabrication d'un écran d'affichage à matrice active conforme à la revendication 1, ce procédé consistant à réaliser une première plaque (10) portant des premières armatures de condensateurs (22), des transistors à couches minces (20), des lignes (14) et des colonnes (12) conductrices d'adressage, et à réaliser une plaque supérieure (24) revêtue d'une contre-électrode (26) formant seconde armature des condensateurs, ce procédé comprenant, pour réaliser la plaque inférieure, les opérations suivantes :
   - dépôt sur un substrat isolant (50) d'une couche d'un premier matériau conducteur (52, 54),
   - première photogravure appliquée à cette couche pour constituer des pavés (51) formant une des armatures des futurs condensateurs, chaque pavé possédant un appendice (53),
   - dépôt d'un empilement constitué d'une couche (60) de silicium amorphe hydrogéné, d'une couche (62) d'un second matériau isolant, d'une couche (64) d'un matériau conducteur,
   - photogravure appliquée à cet empilement pour laisser subsister des lignes, ces lignes passant au-dessus des appendices (53) des pavés, ce procédé étant caractérisé par le fait que :
   - la première photogravure laisse subsister en outre des bandes (55) ayant une partie longitudinale (55l) s'étendant le long du pavé et de son appendice et une partie transversale (55t) et des colonnes (57) en contact avec la partie transversale des bandes,
   - avant le dépôt de l'empilement on dépose une couche d'un matériau isolant (58), ce dépôt étant suivi d'une photogravure additionnelle appliquée à cette couche isolante pour laisser cet isolant sur les colonnes,
   - les lignes passent au-dessus de l'extrémité des bandes (55) et ont une largeur pouvant être supérieure dans la région des transistors à celle dans les régions où elles croisent les colonnes.

**Claims**

1. Active matrix display screen having a first plate (10) coated with a matrix of conductive blocks (22), thin film control transistors (20), a family of conductive addressing lines (14) and a family of conductive addressing columns (12), each transistor (20) having a gate connected to a line, a source formed by an appendix connected to a block and a drain connected to a column, said screen also having a second plate (24) with a counterelectrode (26) and an electrooptical material inserted between the two plates, said screen being characterized in that each drain-column connection takes place by a conductive material strip (55) having a resistance, whose value is such that it protects the column if the transistor is subject to a breakdown and the potential drop across said resistance is below a fraction of a volt when the transistor is conductive, the drain of each transistor being formed by that portion of the strip located in the zone where a line overlaps said strip and in that each line has a certain width in the zone where the transistors are formed and another width, which is smaller than the first, in the zone where it crosses an addressing column.

2. Display screen according to claim 1, characterized in that the conductive strip (55) is made from the material (52) used for forming the conductive blocks.

3. Conductive screen according to claim 2, characterized in that this material is indium-tin oxide (ITO).

4. Process for the production of an active matrix display screen according to claim 1, said process consisting of producing a first plate (10) carrying first capacitor plates (22), conductive addressing columns (12) and lines (14) and producing an upper wall (24) covered by a counterelectrode (26) forming the second plate of the capacitors, said process comprising, for producing the lower plate, the following operations: deposition on an insulating substrate (50) of a layer of a first conductive material (52, 54),
first photoetching applied to said layer in order to constitute blocks (51) forming one of the plates of the future capacitors, each block having an appendix (53),
deposition of a stack constituted by a hydrogenated amorphous silicon layer (60), an insulating material layer (62) and a conductive material layer (64),
photoetching applied to said stack in order to leave behind lines passing above appendixes (53) of the blocks,
said process being characterized in that:
the first photoetching also leaves behind strips (55) having a longitudinal portion (55l) extending along the block and its appendix and a transverse portion (55t),
prior to the deposition of the stack, deposition takes place of a layer of a conductive material (56) and a layer of an insulating material (58), said deposition being followed by an additional photoetching applied to said two latter layers in order to leave behind columns parallel to the longitudinal portion (55l) of the strips and in contact with the transverse portion (55t) of said strips,
the lines pass above the end of the strips (55) and have a width which can be greater in the region of the transistors than that in the regions where they cross the columns.

5. Process for the production of an active matrix display screen according to claim 1, said process consisting of producing a first plate (10) carrying first capacitor plates (22), thin film transistors (20), conductive addressing columns (12) and lines (14) and producing an upper plate (24) covered by a counterelectrode (26) forming the second plate of the capacitors, said process comprising, for producing the lower plate, the following operations: deposition on an insulating substrate (50) of a first layer of a first conductive material (52, 54),
first photoetching applied to said layer to constitute blocks (51) forming one of the plates of the future capacitors, each block having an appendix (53),
deposition of a stack constituted by a hydrogenated amorphous silicon layer (60), a second insulating material layer (62) and a conductive material layer (64),
photoetching applied to said stack in order to leave behind lines, said lines passing above the appendixes (53) of the blocks,
said process being characterized in that:
the first photoetching also leaves behind strips (55) having a longitudinal portion (55l) extending along the block and its appendix and a transverse portion (55t) and columns (57) in contact with the transverse portion of the strips,
prior to the deposition of the stack, deposition takes place of a layer of an insulating material (58), said deposition being followed by an additional photoetching applied to said insulating layer in order to leave said insulant on the columns,
the lines pass above the end of the strips (55) and have a width which can be greater in the region of the transistors than that in the regions where they cross the columns.

**Patentansprüche**

1. Anzeigebildschirm mit aktiver Matrix, der eine erste Platte (10) aufweist, die mit einer Matrix aus leitenden Plättchen (22), Dünnschichtsteuertransistoren (20), einer Gruppe von leitenden Adreßzeilen (14) und einer Gruppe von leitenden Adreßspalten (12) bedeckt ist, wobei jeder Transistor (20) ein Gitter aufweist, das mit einer Zeile verbunden ist, eine Quelle aufweist, die durch ein Ansatzstück gebildet wird, das mit einem Plättchen verbunden ist, und ein Drainanschluß mit einer Spalte verbunden ist, wobei der Bildschirm weiterhin eine zweite Platte (24) aufweist, die eine Gegenelektrode (26) und ein eletrooptisches Material aufweist, das zwischen den beiden Platten eingesetzt ist, wobei der Bildschirm dadurch gekennzeichnet ist, daß jede Verbindung Drain-Spalte durch ein Band (25) aus leitendem Material erzeugt wird, das einen Widerstand aufweist, dessen Wert größer ist als jener, der die Spalte schützt, wenn der Transistor durchbricht, und daß der Potentialabfall über den Widerstand geringer ist als ein Voltbruch, wenn der Transistor durchlassend ist, wobei der Drain eines jeden Transistors gebildet wird durch den Bereich des Bandes, der in der Zone angeordnet ist, wo eine Zeile dieses Band überschneidet und dadurch, daß jede Zeile eine gewisse Breite in der Zone aufweist, wo die Transistoren gebildet sind und eine andere Breite aufweist, die geringer ist als die erste in der Zone, wo sie eine Adreßspalte kreuzt.

2. Anzeigebildschirm nach Anspruch 1, dadurch gekennzeichnet, daß das Leiterband (25) aus demselben Material (52) gebildet wird, das die Leiterplättchen bildet.

3. Anzeigebildschirm nach Anspruch 2, dadurch gekennzeichnet, daß das Material Zinn-Indiumoxid (ITO) ist.

4. Verfahren zur Herstellung eines Anzeigebildschirms mit aktivem Matrix nach Anspruch 1, wobei das Verfahren darin besteht, eine erste Platte (10) herzustellen, die erste Kondensatorarmaturen (22), Dünnsschichttransistoren (20), leitende Adreßzeilen (14) und Adreßspalten (12) trägt, um eine obere Seitenwand (24) herzustellen, die mit einer Gegenelektrode (26) überzogen ist, die eine zweite Kondensatorarmatur bildet, wobei das Verfahren, um die untere Platte herzustellen, die folgenden Schritte aufweist:

Ablegen einer ersten Schicht eines ersten leitenden Materials (52,54) auf einem isolierenden Substrat (50),

erste Fotoätzung, angewandt auf diese Schicht, um Plättchen (51) zu bilden, die die Armaturen der zukünftigen Kondensatoren bilden, wobei jedes Plättchen ein Ansatzstück (53) aufweist,

Ablegen einer Schichtung, gebildet aus einer Schicht (60) aus wasserangereichertem amorphem Silicium, einer Schicht (62) aus einem isolierenden Material, einer Schicht (64) eines leitenden Materials,

Fotoätzung, angewandt auf diese Schichtung, um Zeilen übrigzulassen, die oberhalb der Ansatzstücke (53) der Plättchen vorbeigehen,

wobei das Verfahren dadurch gekennzeichnet ist, daß:

die erste Fotoätzung weiterhin Bänder (55) überläßt, die einen Längsbereich (55l) aufweisen, der sich entlang des Plättchens unter einem Ansatzstück erstreckt und einen Querbereich (55t) aufweist,

vor dem Ablegen der Schichtung eine Schicht eines leitenden Materials (56) und eine Schicht eines Isolatormaterials abgelegt wird, wobei diese Ablage von einer zusätzlichen aufgebrachten Fotoätzung gefolgt wird, auf die beiden letzten Schichten, um parallele Spalten an dem Längsbereich (55l) der Bänder übrigzulassen und in Verbindung mit dem Querbereich (55t) dieser Bänder zu lassen,

die Zeilen oberhalb des Endes der Bänder (55) vorbeigehen, und eine Breite aufweisen, die größer sein kann in dem Bereich der Transistoren als jene in den Bereichen, wo sie die Spalten kreuzen.

5. Verfahren zum Herstellen eines Anzeigebildschirms mit aktiver Matrix nach Anspruch 1, wobei das Verfahren daraus besteht, eine este Platte (10), die erste Kondensatorarmatur (22), Dünnschichttransistoren (20), leitende Adreßzeilen (14) und Adreßspalten (12) trägt, herzustellen, und eine obere Platte (24) herzustellen, die mit einer Gegenelektrode (26) belegt ist, die eine zweite Kondensatorenarmatur bildet, wobei das Verfahren, um die untere Platte herzustellen, die folgenden Schritte aufweist:

Ablegen auf einem Isolatorsubstrat (50) einer Schicht eines ersten Leitermaterials (52,54),

erste Fotoätzung, aufgebracht auf diese Schicht, um Plättchen (51) zu bilden, die eine der Armaturen der zukünftigen Kondensatoren bilden, wobei jedes Plättchen ein Ansatzstück (53) aufweist,

Ablegen einer Schichtung, gebildet aus einer Schicht (60) aus amorphem wasserangereichertem Silicium, einer Schicht (62) eines zweiten Isolatormaterials, einer Schicht (64) eines Leitermaterials,

Fotoätzung, aufgebracht auf diese Schichtung, um Zeilen zurückzulassen, wobei diese Zeilen oberhalb der Ansatzstücke (53) der Plättchen vorbeigehen,

wobei das Verfahren dadurch gekennzeichnet ist, daß:

die erste Fotoätzung darüber hinaus Bänder (55) überläßt, die einen Längsbereich (55l) haben, der sich entlang des Plättchens und seines Ansatzstückes erstreckt und einen Querbereich (55t) und Spalten (55) in Berührung mit dem Querbereich der Bänder haben,

vor dem Ablegen der Schichtung eine Schicht Isolatormaterial (58) abgelegt wird, wobei dieses Ablegen von einer zusätzlichen Fotoätzung gefolgt wird, angewendet auf diese Isolatorschicht, um diesen Isolator auf den Spalten zu lassen,

die Zeilen oberhalb des Endes der Bänder (55) vorbeigehen und eine Breite aufweisen, die größer sein kann in dem Bereich der Transistoren als jene in den Bereichen, wo sie die Spalten kreuzen.

FIG. 1

FIG. 2

**FIG. 3**

**FIG. 4**

**FIG. 5**